# EUROPEAN PATENT APPLICATION

(11) **EP 4 601 004 A1**
(43) Date of publication of application: **13.08.2025**
(21) Application number: 25156899.4
(22) Date of filing: 10.02.2025
(51) Int. Cl.: H01L 23/495, H01L 23/00

(54) **MOLDED SPACER FOR SURFACE MOUNT TECHNOLOGY**

(30) Priority: 09.02.2024 US 202418437784
(71) Applicant: Google LLC, Mountain View, CA 94043 (US)
(72) Inventor: TENG, Sue Yun, Mountain View, California, 94043 (US); TANG, Yingshi, Mountain View, California, 94043 (US)
(74) Representative: Betten & Resch

(57) **Abstract**

Methods, systems, and apparatus, for a molded spacer. In an aspect, a spacer comprises a core defining a top surface, a bottom surface, and one or more side surfaces; a molded covering that covers at least the top surface of the core, the molded covering comprising an insulation material, wherein the spacer has a cross sectional size to fit onto a depopulated connection pad of a ball grid array of a circuit board without interfering in a reflow soldering operation for solder balls placed on connection pads immediately adj acent to the depopulated connection pad.

## Description

### BACKGROUND

Ball grid arrays (BGAs) and their variants are prevalent for surface mount packaging in integrated circuits. As the body size of BGA packages continues to grow, e.g., greater than 65 mm sq., the coplanarity and warpage of these packages continues to increase. Similarly, as the package footprint on the printed circuit board (PCB) grows with the package body size, the coplanarity and warpage of the PCB in the package footprint area may also increase. Moreover, as the package body sizes continue to grow, there is also a trend to move to BGA pitches to less than 1mm from orthogonal BGA arrays to hexagonal BGA arrays. These changes are to accommodate higher I/O and allow for higher data speeds without incurring resonance effects that would degrade signal integrity.

All of these factors contribute to increasing challenges in being able to achieve high yields for surface mount technologies (SMT). One way of adding process margin is to include spacers at certain locations underneath the integrated circuit (IC) package where there is increased risk for bridging. These spacers limit the amount of collapse of the solder joint and help to mitigate potential solder bridging. Typically, these spacers are used in the four corner areas. These spacers, however, are typically solid metal and are provided in a standard size. Thus, when these spacers are placed elsewhere from the four corner areas, e.g., within an internal region of the BGA, several BGA pads must be depopulated to accommodate the spacer. This reduces functional density, which, in turn, reduces other performance characteristics, such as I/O capacity, etc.

### SUMMARY

A molded spacer allows for a customized spacer size that can be soldered to a single BGA pad. This allows for spacers to be placed in areas internal to the BGA array while only taking the location of a single pad on which a solder ball could otherwise be placed. Additionally, because the overall size of the spacer can be easily controlled by molding process, a wider variety of spacer sizes is made available.

In general, one innovative aspect of the subject matter described in this specification can be embodied in a method comprising the operations of: positioning within a molding apparatus a lead frame comprising a plurality of cores, each core defining a top surface, a bottom surface, and one or more side surfaces; molding, using the molding apparatus, to the top surfaces of the cores, a covering that, for each core, covers the top surface of the core, and wherein the covering is an insulating material; and singulating the cores from the lead frame to obtain a plurality of spacers, wherein each spacer is a core with its top surface covered by the covering.

These and other embodiments can each optionally include one or more of the following features. In an aspect, the lead frame comprises a solder pad layer on a side of the lead frame so that each bottom surface of each core is covered by a solder layer.

In another aspect, each core of the plurality of cores includes a solderable surface plating on a bottom surface. The core can be a copper core, and the surface plating can be NiAu.

In another aspect, each core has a first height defined by a distance between the top surface and the bottom surface of the core; and the method further comprises: defining a specified height for the plurality of spacers, wherein the specified height is greater than the first height of the cores; and wherein molding to the top surface of the cores to the covering comprises molding the covering to a specified thickness such that a combination of the first height and the specified thickness is at least equal to the specified height.

In another aspect, the specified height is adjustable for each molding operation so that each molding operation can produce spacers of a specified height that is different from a specified height of other molding operations.

In another aspect, the molding operation is a book molding operation.

In another aspect, molding, using the molding apparatus, to the top surfaces of the cores, the covering comprises molding the covering to the top and side surfaces of the cores.

In another aspect, the cores comprise a circular cross section, and wherein a diameter of the core is approximately equal to a ball grid array ball diameter.

In another aspect, the cores comprise a circular cross section of a diameter that is approximately equal to a ball grid array ball diameter.

Another innovative aspect of the subject matter described in this specification can be embodied in a method comprising: determining a plurality of connection pads on a top side of the circuit board that are depopulated connection pads; for each depopulated connection pad, placing on the connection pad a spacer comprising: a core defining a top surface, a bottom surface, and one or more side surfaces, a molded covering that covers the top surface of the core, and wherein the covering is an insulating material, and wherein the spacer has a first height measured from the bottom surface of the core to a top surface of the molded covering and is placed such that the bottom side of the spacer is nearest the connection pad of the circuit board; placing an integrated circuit that has on a bottom side a plurality of connection pads so that solder balls connect the connection pads of the integrated circuit to the connection pads of the circuit board that are not depopulated, and wherein the solder balls are of a second height greater than the first height of the spacer; and reflow soldering the integrated circuit to the ball grid array; wherein after the reflow soldering a distance between the bottom side of the integrated circuit and the top side of the circuit board is limited to the first height by the spacer.

These and other embodiments can each optionally include one or more of the following features. In an aspect, the grid of connection pads is a two-dimensional grid defining interior connection pads and edge connection pads surrounding the interior connection pads, and the depopulated connection pads include connection pads that are interior connection pads.

In another aspect, the one or more side surfaces are covered by the molded covering.

In another aspect, the bottom side of the spacer is covered by a solder pad layer, and during the reflow soldering, the spacer is soldered to the depopulated connection pad by the solder pad layer.

Yet another innovative aspect of the subject matter described in this specification can be embodied in a spacer, comprising: a core defining a top surface, a bottom surface, and one or more side surfaces; a molded covering that covers at least the top surface of the spacer, the molded covering comprising an insulation material; and wherein the spacer has a cross sectional size to fit onto a depopulated connection pad of a ball grid array of a circuit board without interfering in a reflow soldering operation for solder balls placed on connection pads immediately adjacent to the depopulated connection pad.

These and other embodiments can each optionally include one or more of the following features. In an aspect, the spacer has a first height measured from the bottom surface of the core to a top surface of the molded covering and is placed such that the bottom side of the spacer is nearest the connection pad of a circuit board; and the first height is less than a height of a solder ball prior to a reflow operation and that that is attached to other connection pads.

In another aspect, the one or more side surfaces are covered by the molded covering.

In another aspect, the bottom side of the spacer is covered by a solder pad layer, and during reflow soldering, the spacer is soldered to the depopulated connection pad by the solder pad layer.

In another aspect, the core is copper.

Particular embodiments of the subject matter described in this specification can be implemented so as to realize one or more of the following advantages. In some implementations, an overmold process is used to mold a disk shape with specific height and diameter dimensions as defined by the mold tooling. The mold tooling allows for easier control of dimensions than would otherwise be required if a solid metal spacer were used. This mold tooling can be used to mold many of these spacers at a single time for low cost and high throughput.

In some implementations, solderable pads can be designed into a lead frame. These pads can be designed to accommodate a custom pad diameter at the base of the molded spacer that can be soldered to the BGA pad. A stamped lead frame process can be utilized for the geometric design and is very economical for high volume production. Additionally, in some implementations, the flat top surface of the molded spacer can accommodate a standard pick and place process for SMT.

The details of one or more embodiments of the subject matter described in this specification are set forth in the accompanying drawings and the description below. Other features, aspects, and advantages of the subject matter will become apparent from the description, the drawings, and the claims.

### BRIEF DESCRIPTION OF THE DRAWINGS

Figs. 1A - 1C are perspective, side and bottom views of a molded spacer.
Figs. 2A and 2B are side views of a package that is an integrated circuit being soldered to a circuit board by a BGA.
Fig. 3 is a top view of a BGA that has a central pad populated by a molded spacer.
Fig. 4 is a top view of a lead frame used to fabricate molded spacers.
Fig. 5 is a flow diagram of an example process for fabricating a molded spacer.
Fig. 6 is a flow diagram of an example process for using molded spacers in a reflow operation.

Like reference numbers and designations in the various drawings indicate like elements.

### DETAILED DESCRIPTION

This disclosure describes methods, systems, and apparatus, for a molded spacer. In an aspect, a spacer comprises a core defining a top surface, a bottom surface, and one or more side surfaces; a molded covering that covers at least the top surface of the core, the molded covering comprising an insulation material, wherein the spacer has a cross sectional size to fit onto a depopulated connection pad of a ball grid array of a circuit board without interfering in a reflow soldering operation for solder balls placed on connection pads immediately adjacent to the depopulated connection pad.

This disclosure describes a molded spacer that is customizable in size by an overmolding process. In some implementations, the spacer is designed to be soldered to a single BGA pad. However, in other implementations, the spacer may take up two or more BGA pads.

When the spacer is designed to be soldered to a single BGA pad, the size of the spacer is such that when placed in areas internal to the BGA array, only one BGA pad need be depopulated. The BGA pads adjacent to the depopulated BGA pad to which the spacer is attached may still be used for electrical connections.

These features and additional features are described in more detail below.

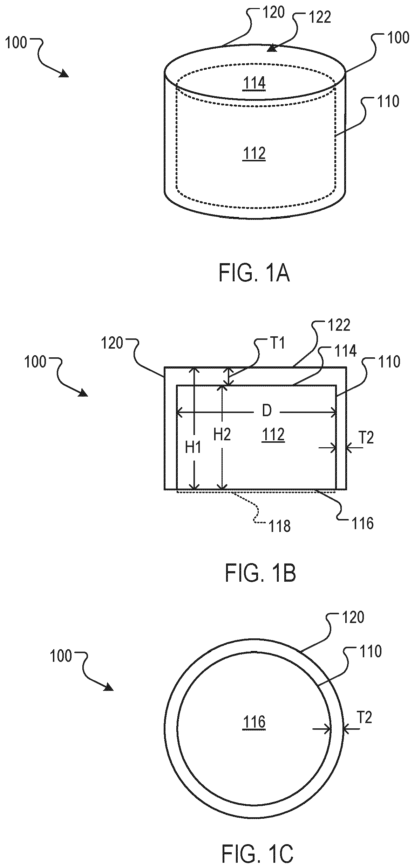

Figs. 1A - 1C are perspective, side and bottom views of a molded spacer 100. In the example implementation of Figs. 1A - 1C, the spacer 100 has a core 110 defining a top surface 114, one or more side surfaces 112, and a bottom surface 116. The example spacer 100 in this specification is cylindrical in shape, but other shapes, such as cubic shapes, can be used. The core 110 may be a solid core of metal, such as copper, aluminum, or any other metal or alloy that can be soldered to a pad of a ball grid array. In other implementations, non-metallic cores can be used. In some implementations, a material that is capable of being soldered to a BGA pad can be used, e.g., a metal or ceramic core that can be attached to the BGA pad by soldering can be used.

A molded covering 120 covers at least the top surface 114 of the metal core 110. In some implementations, the molded covering is a non-conductive material, e.g., epoxy cresol novolac, a thermoplastic, e.g., polyetheretherketone, polyamide-imide, acetal, etc., or some other material that can be molded to the metal core 110. As shown in Figs. 1A - 1C, the covering 120 also covers the side of the metal core 110, but in some implementations, the covering 120 can be deposited only on the top surface 114.

In some implementations, the spacer 100 has a circular cross section, defined by the diameter D, to fit onto a depopulated connection pad of a BGA of a circuit board. The circular cross section can be of a diameter D that is approximately equal to a ball grid array ball diameter for a BGA for which the spacer 100 is to be used. The size is such that when placed, the spacer 100 will not interfere in a reflow soldering operation for solder balls placed on connection pads immediately adjacent to the depopulated connection pad. The cross sectional size of the spacer 110 will depend on the BGA type, size and pitch for which spacer is designed, e.g., BGA, FBGA, FCBGA, MGBA, orthogonal BGAs, and hexagonal BGAs.

In implementations where a rectangular cross section is used, the area of the rectangular cross section is selected such that it provides sufficient surface area to be soldered to the BGA pad to which it is being attached.

As depicted in Figs. 1A - 1C, the spacer 100 has a first height H1 measured from the bottom surface 116 of the metal core 110 to a top surface 122 of the molded covering 120. The height H1 is equal to the height H2 of the metal core 110 and thickness T1 of the molded covering 120. In some implementations, the thickness T1 can be adjusted by a molding process to facilitate different overall heights H1.

For example, the overall height H1 may be based on defined, specified height for the spacer 100. Because the height H1 is greater than the height H2 of the metal core 100, the thickness T1 is determined such that the combined height H1 is at least equal to the specified height. Accordingly, when applying the molded covering 120 to the metal core 110 during an overmolding process to form the spacer 100, the covering 120 is molded to the specified thickness T1 such that the combination of the first height H1 and the specified thickness T1 is at least equal to the specified height H1. The thickness T2 of the side covering may be the same as the thickness T1 of the top covering, or may be different.

In some implementations, the specified height H1 may be 12, 14 or 16 mils, depending on the specific application. The diameter D may also be defined for specific applications, e.g., 18 or 20 mils, for example. The thickness T2 of the sides may then be selected for an overall diameter, e.g., 20 or 22 mils for an 18 or 20 mil metal core 110 diameter.

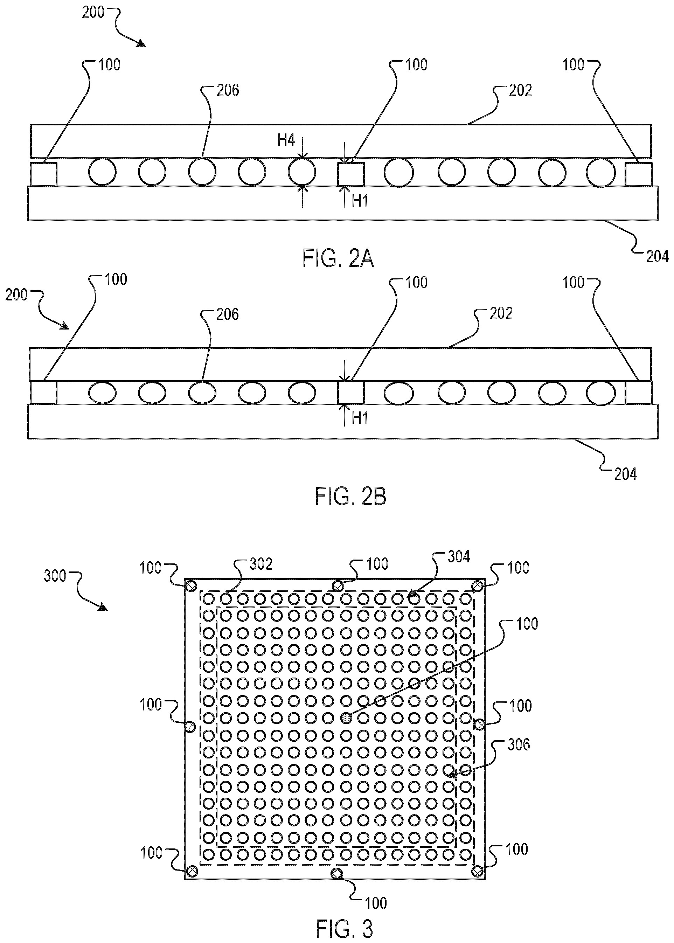

The bottom side 116 of the spacer 100 is placed on a connection pad of a circuit board. As will be described with reference to Figs. 2A and 2B, the first height H1 is less than a height of a solder ball prior to a reflow operation.

In some implementations, the bottom side 116 of the core 110 is covered by a solder pad layer 118, as illustrated in phantom detail in Fig. 1B. During reflow soldering, the spacer 100 is soldered to the depopulated connection pad by the solder pad layer 118.

In other implementations, the bottom side of the core 110 is bare. For example, if the core 110 is metal, the bottom side of the core 110 is bare metal. In other implementations, instead of a solder pad layer 118, the layer by a plating that is solderable, e.g., a NiAu layer.

Figs. 2A and 2B are side views of a package 200 that is an integrated circuit 202 being soldered to a circuit board 204 by a BGA. As shown in Fig. 2A, prior to a reflow operation, the solder balls 206 that are attached to the connection pads each have a height H4. The solder ball height H4 is greater than the first height H1 of the spacer 100. Atop the solder balls 206 an integrated circuit 202 is placed. The bottom side of the integrated circuit 202 has connection pads aligned atop the solder balls 206.

Once prepared, the package undergoes a reflow soldering operation to solder the integrated circuit 202 to the ball grid array of the circuit board 204. During the reflow soldering operation, the solder balls 206 deform, and their height decreases. However, the spacers 100 limit the distance between the bottom side of the integrated circuit 202 and the top side of the circuit board 204 to the first height H1, as illustrated in Fig. 2B.

Fig. 3 is a top view of a BGA 300 that has a central pad populated by a molded spacer 100. In the example BGA 300 of Fig. 3, the BGA has a two-dimensional grid of connection pads 302. Edge connection pads 302 within an edge region 304 surround interior connection pads 302 within an interior region 306. A molded spacer 100 is positions near the center of the BGA within interior region 306. As shown in Fig. 3, the spacer 100 requires only the depopulation of a single connection pad in the interior region 306.

Additional spacers 100 may be located near the periphery, e.g., outside the edge region 302 and outside the interior region 306. In other implementations, connection pads 302 in the edge region 304 may be depopulated for the peripheral placement of spacers 100.

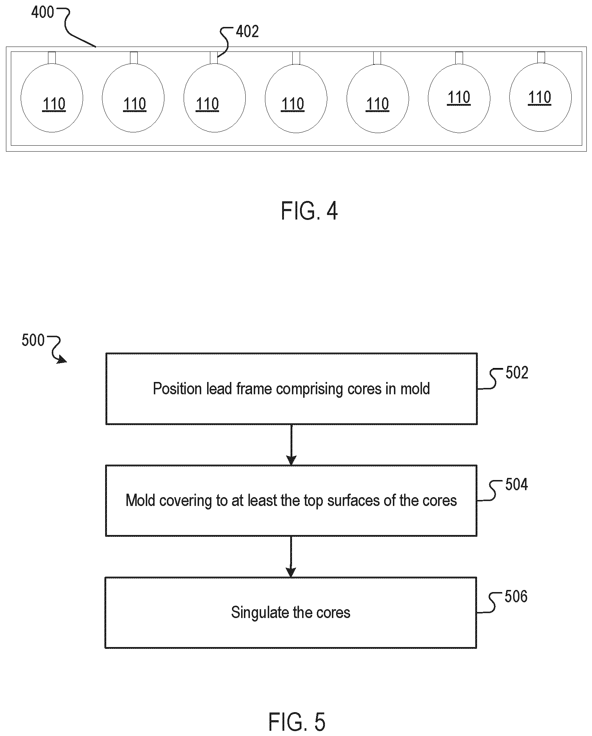

Fig. 4 is a top view of a lead frame 400 used to fabricate molded spacers. The lead frame 400 includes multiple metal cores 110 that are connected by metal tabs 402. The lead frame 400 can include a solder pad layer on a side of the lead frame so that each bottom surface of each metal core 110 is covered by a solder layer.

The lead frame 400 may be placed in a book mold, for example, for an overmolding operation to create spacers 100 of a specified height H1. After the operation, the spacers 100 are singulated.

Fig. 5 is a flow diagram of an example process 500 for fabricating a molded spacer. The process 500 can be done, for example, by using a book mold system. Other injection molding systems or even deposition systems can also be used.

The process 500 positions a lead frame comprising cores in a mold (502). The cores and lead frame can be as described in Figs. 1A - 1C and Fig. 4.

The process 500 molds a covering to at least the top surfaces of the cores (504). For example, the covering 120 of Figs. 1A - 1C can be molded onto metal cores 110. The thickness of the covering may be selected so the finished spacer 100 is equal to the specified height. The specified height can be adjustable between molding operations, so each molding operation can produce spacers of a specified height that is different from a specified height of other molding operations.

The process 500 singulates the cores (504). The metal cores from the lead frame are singulated to obtain multiple spacers 100. Each spacer 100 is the core 110 covered by the covering 120.

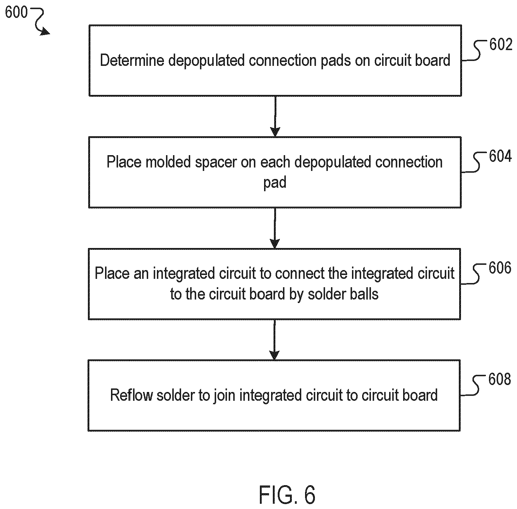

Fig. 6 is a flow diagram of an example process 600 for using molded spacers in a reflow operation. The process 600 can be done, for example, by using equipment for a reflow soldering operation.

The process 600 determines depopulated connection pads on circuit board (602). For example, as show in Fig. 3, one or more central BGA pads in the interior area 306 can be designated as a depopulated connection pad.

The process 600 places a molded spacer on each depopulated connection pad (604). For example, a pick and place device may place the spacer 100 on the depopulated connection pad. A solder pad may be on the bottom of the spacer 100, or may be applied to either the bottom of the spacer 100 or the depopulated connection pad before placement.

The process 600 places an integrated circuit to connect the integrated circuit to the circuit board by solder balls (606). For example, as shown in Fig. 2A, the integrated circuit 202 may be placed in preparation for a reflow soldering operation. The integrated circuit 202 is, for example, placed such that the connection pads on the bottom of the integrated circuit 202 are connected by solder balls to the connection pads of the circuit board 204 that are not depopulated.

The process 600 reflow solders to join the integrated circuit to the circuit board (608). The spacers 100 maintain the specified height H1 to separate the integrated circuit 202 from the circuit board 204 during the soldering operation.

While this specification contains many specific implementation details, these should not be construed as limitations on the scope of any features or of what may be claimed, but rather as descriptions of features specific to particular embodiments. Certain features that are described in this specification in the context of separate embodiments can also be implemented in combination in a single embodiment. Conversely, various features that are described in the context of a single embodiment can also be implemented in multiple embodiments separately or in any suitable subcombination. Moreover, although features may be described above as acting in certain combinations and even initially claimed as such, one or more features from a claimed combination can in some cases be excised from the combination, and the claimed combination may be directed to a subcombination or variation of a subcombination.

Similarly, while operations are depicted in the drawings in a particular order, this should not be understood as requiring that such operations be performed in the particular order shown or in sequential order, or that all illustrated operations be performed, to achieve desirable results. In certain circumstances, multitasking and parallel processing may be advantageous. Moreover, the separation of various system components in the embodiments described above should not be understood as requiring such separation in all embodiments, and it should be understood that the described program components and systems can generally be integrated together in a single software product or packaged into multiple software products.

Thus, particular embodiments of the subject matter have been described. Other embodiments are within the scope of the following claims. In some cases, the actions recited in the claims can be performed in a different order and still achieve desirable results. In addition, the processes depicted in the accompanying figures do not necessarily require the particular order shown, or sequential order, to achieve desirable results. In certain implementations, multitasking and parallel processing may be advantageous.

## Claims

1. A method comprising the operations of:
positioning within a molding apparatus a lead frame comprising a plurality of cores, each core defining a top surface, a bottom surface, and one or more side surfaces;
molding, using the molding apparatus, to the top surfaces of the cores, a covering that, for each core, covers the top surface of the core, and wherein the covering is an insulating material; and
singulating the cores from the lead frame to obtain a plurality of spacers, wherein each spacer is a core with its top surface covered by the covering.

2. The method of claim **1,** wherein the lead frame comprises a solder pad layer on a side of the lead frame so that each bottom surface of each core is covered by a solder layer.

3. The method of claim 1 or 2,
wherein each core of the plurality of cores includes a solderable surface plating on a bottom surface; and/or
wherein each core is a copper core, and the surface plating is NiAu.

4. The method of one of claims 1 to 3, wherein:
each core has a first height defined by a distance between the top surface and the bottom surface of the core; and
the method further comprises:
defining a specified height for the plurality of spacers, wherein the specified height is greater than the first height of the cores;
wherein molding to the top surface of the cores to the covering comprises molding the covering to a specified thickness such that a combination of the first height and the specified thickness is at least equal to the specified height; and
wherein, optionally, the specified height is adjustable for each molding operation so that each molding operation can produce spacers of a specified height that is different from a specified height of other molding operations.

5. The method of claim one of claims 2 to 4, wherein the molding operation is a book molding operation.

6. The method of claim 5,
wherein molding, using the molding apparatus, to the top surfaces of the cores, the covering comprises molding the covering to the top and side surfaces of the cores; or
wherein the cores comprise a circular cross section, and wherein a diameter of the core is approximately equal to a ball grid array ball diameter.

7. The method of one of claims 2 to 4, wherein the cores comprise a circular cross section of a diameter that is approximately equal to a ball grid array ball diameter.

8. The method of one of claims 1 to 7, wherein the core is copper.

9. A method of mounting an integrated circuit to a ball grid array of a circuit board, wherein the ball grid array defines a grid of connection pads, the method comprising:
determining a plurality of connection pads on a top side of the circuit board that are depopulated connection pads;
for each depopulated connection pad, placing on the connection pad a spacer comprising:
a core defining a top surface, a bottom surface, and one or more side surfaces;
a molded covering that covers the top surface of the core, and wherein the covering is an insulating material; and
wherein the spacer has a first height measured from the bottom surface of the core to a top surface of the molded covering and is placed such that the bottom side of the spacer is nearest the connection pad of the circuit board;
placing an integrated circuit that has on a bottom side a plurality of connection pads so that solder balls connect the connection pads of the integrated circuit to the connection pads of the circuit board that are not depopulated, and wherein the solder balls are of a second height greater than the first height of the spacer; and
reflow soldering the integrated circuit to the ball grid array;
wherein after the reflow soldering a distance between the bottom side of the integrated circuit and the top side of the circuit board is limited to the first height by the spacer.

10. The method of claim 9, wherein the grid of connection pads is a two-dimensional grid defining interior connection pads and edge connection pads surrounding the interior connection pads, and the depopulated connection pads include connection pads that are interior connection pads.

11. The method of claim 9 or 10,
wherein the one or more side surfaces are covered by the molded covering; and/or
wherein the bottom side of the spacer is covered by a solder pad layer, and during the reflow soldering, the spacer is soldered to the depopulated connection pad by the solder pad layer.

12. A spacer, comprising:
a core defining a top surface, a bottom surface, and one or more side surfaces;
a molded covering that covers at least the top surface of the spacer, the molded covering comprising an insulation material; and
wherein the spacer has a cross sectional size to fit onto a depopulated connection pad of a ball grid array of a circuit board without interfering in a reflow soldering operation for solder balls placed on connection pads immediately adjacent to the depopulated connection pad.

13. The spacer of claim 12, wherein:
the spacer has a first height measured from the bottom surface of the core to a top surface of the molded covering and is placed such that the bottom side of the spacer is nearest the connection pad of a circuit board; and
the first height is less than a height of a solder ball prior to a reflow operation and that that is attached to other connection pads.

14. The spacer of claim 12 or 13, wherein the one or more side surfaces are covered by the molded covering.

15. The spacer of one of claims 12 to 14,
wherein the bottom side of the spacer is covered by a solder pad layer, and during reflow soldering, the spacer is soldered to the depopulated connection pad by the solder pad layer; and/or
wherein the core is copper.
